# EUROPÄISCHE PATENTSCHRIFT

(11) **EP 0 713 242 B1**
(45) Veröffentlichungstag und Bekanntmachung des Hinweises auf die Patenterteilung: **26.01.2000**
(21) Anmeldenummer: 95116842.6
(22) Anmeldetag: 26.10.1995
(51) Int. Cl.: H01J 37/34

(54) **Einrichtung für die Unterdrückung von überschlägen in Kathoden-Zerstäubungseinrichtungen**
Device for suppressing arcing in cathode sputtering installations
Dispositif pour la suppression de claquages dans les installations de pulvérisation cathodique

(30) Priorität: 19.11.1994 DE 4441206
(43) Veröffentlichungstag der Anmeldung: 22.05.1996
(73) Patentinhaber: Balzers und Leybold Deutschland Holding Aktiengesellschaft, 63450 Hanau (DE)
(72) Erfinder: Maass, Wolfram, Dr., D-63589 Linsengericht-Grossenhausen (DE)
(74) Vertreter: Schickedanz, Willi, Dipl.-Ing.

(56) Entgegenhaltungen:
- WO-A-91/15027
- GB-A- 2 187 904
- US-A- 4 700 315

## Beschreibung

Die Erfindung betrifft eine Einrichtung nach dem Oberbegriff der Patentansprüche 1 und 2

Beim Kathodenzerstäuben zum Zweck der Herstellung dünner Schichten mit Hilfe der Mittelfrequenztechnik, bei der in einem Frequenzbereich von einigen hundert Hz bis einigen hundert kHz gearbeitet wird, können Bogenentladungen entstehen, die sowohl die herzustellenden Schichten als auch die beim Zerstäuben verwendeten Targets beschädigen oder zerstören können. Dies gilt in besonderem Maß für die Herstellung dielektrischer Schichten mittels Reaktivgastechnik, bei der ein Reaktivgas in den Rezipienten eingelassen wird, mit dem das zerstäubte Targetmaterial am Substrat reagieren kann. Beispielsweise wird zu zerstäubten Aluminium als Reaktivgas O₂ gegeben, um eine dünne Schicht aus Al₂O₃ herzustellen.

Es sind indessen bereits zahlreiche Einrichtungen vorgeschlagen worden, mit denen es möglich ist, auftretende Bogenentladungen zu erkennen, zu unterbrechen oder gar nicht erst entstehen zu lassen (Deutsche Offenlegungsschriften DE-A-38 21 207, DE-A-41 27 504, DE-A-41 27 505, DE-A-42 30 779, DE-A-42 39 218, DE-A-42 02 425, DE-A-42 42 633, Europäische Veröffentlichungsschrift EP-A-0 544 107, USA-Patentschrift US-A-5 192 894). Diese Einrichtungen eignen sich jedoch entweder nicht für Anlagen, die mit Wechselspannungen arbeiten, oder sie sind zum Erkennen und Unterdrücken von Überschlägen in der "Keimphase", d. h. von Kleinst-Überschlägen oder Mikro-Arcs, ungeeignet. In GB-A-2 187 904 ist eine Einrichtung beschrieben, mit welcher unerwünschte Überschläge ausgelöscht werden können. Diese Einrichtung betrifft jedoch keine Kathoden-Zerstäubungseinrichtung.

Kleinst-Überschläge oder Mikro-Arcs, die sich mit einem Oszilloskop beobachten lassen, treten nur über einer Halbwelle oder über einigen wenigen Halbwellen der anliegenden Wechselspannung auf. Bei einer Wechselspannungsfrequenz von 40 kHz bedeutet dies, daß die Arcs nur für etwa 12,5 µs oder ein Vielfaches davon auftreten. Insbesondere bei leicht schmelzenden Zerstäubungstargets, etwa aus Al, führen diese Mikro-Arcs zu Schädigungen der herzustellenden Schicht, da bereits die in den Mikro-Arcs vorhandene Energie ausreicht, um Tropfen von einigen µm Durchmesser vom Targetmaterial abzuschmelzen und bis auf das Substrat zu verspritzen. Die Schädigung ist dabei in der Regel um so schlimmer, je länger ein Mikro-Arc andauert.

Mikro-Entladungen treten auch als stille Entladungen im Dielektrikum auf, und zwar in unregelmäßigen Folgen und mit einer Dauer im Nanosekundenbereich. Sie sind räumlich und zeitlich statistisch verteilt. Jede Mikro-Entladung besteht hierbei aus einem dünnen, fast zylindrischen Kanal mit einem eingeschnürten Elektrodenfleck an der Metallelektrode (B. Eliasson, M. Hirth und U. Kogelschatz: Ozone synthesis from oxygen in dielectric barrier discharges, J. Phys. D.: Appl. Phys. 20 (1987) 1421 - 1437). Die stille Entladung wird vorzugsweise in der Plasmachemie angewendet, beispielsweie um Ozon herzustellen (B. Eliasson, U. Kogelschatz: Nonequilibrium Volume Plasma Chemical Processing, IEEE Transactions on Plasma Science, Vol. 19, No. 6, 1991, S. 1063 - 1077). Die erfindungsgemäßen Mikro-Entladungen beziehen sich indessen auf Entladungen im Plasma.

Die Mikro-Arcs sind typisch für das Mittelfrequenz-Sputtern und stellen in der Regel Vorstufen von großen Arcs dar. Dies bedeutet jedoch nicht, daß jeder Mikro-Arc zu einem großen Arc führen muß. Es treten je nach Targetzustand mehr oder weniger häufig Mikro-Arcs auf, ohne daß diese Mikro-Arcs mit konventionellen Methoden überhaupt festgestellt werden können.

Es wurde indessen bereits eine Einrichtung zum Erfassen von Mikroüberschlägen oder Mikro-Arcs vorgeschlagen, die einen Zähler für Mikro-Arcs aufweist (nicht vorveröffentlichte deutsche Patentanmeldung DE-A-44 20 951.7). Bei dieser Einrichtung liegt ein zu beschichtendes Substrat wenigstens einer Zerstäubungskathode gegenüber, wobei eine Elektrode mit einem Target versehen ist. Diese Elektrode ist mit einer Mittelfrequenz-Quelle verbunden. Mittels einer Einrichtung zum Erkennen von Mikroüberschlägen werden diese Mikroüberschläge erfaßt und in einer Zähleinrichtung gezählt. Bei Vorliegen einer bestimmten Zahl von Mikroüberschlägen oder bei Vorliegen einer bestimmten Häufigkeit von Mikroüberschlägen werden Maßnahmen zum Verhindern von großen Überschlägen getroffen.

Aufgabe der vorliegenden Erfindung ist es, den Sputterprozeß schnell abschalten zu können, nachdem eine kritische Anzahl von Mikro-Arcs festgestellt wurde.

Diese Aufgabe wird gemäß den Merkmalen der Patentansprüche 1 und 2 gelöst.

Eine besondere Ausführungsart der Erfindung ist in den Ansprüchen 3-15 angegeben.

Der mit der Erfindung erzielte Vorteil besteht insbesondere darin, daß der in der Sputteranlage verwendete Mittelfrequenzsender bei Auftreten einer kritischen Zahl von Mikro-Arcs schnell abgeschaltet werden kann, wobei je nach Konfiguration der Einrichtung festgelegt wird, ob und wie lange der Mittelfrequenzsender abzuschalten ist, um eine effektive Unterdrückung der Arcfolgen zu erreichen. Mittelfrequenz-Sputteranlagen können sowohl mit einer einzelnen Sputterkathode als auch mit einer Doppelkathoden-Anordnung versehen sein. Somit eignet sich die Erfindung für beide Kathodenanordnungen.

Ein Ausführungsbeispiel der Erfindung ist in der Zeichnung dargestellt und wird im folgenden näher beschrieben. Es zeigen:
- Fig. 1: eine Zerstäubungseinrichtung mit einer Einrichtung zum Erkennen und Unterdrücken von Überschlägen;
- Fig. 2: ein Blockschaltbild, welches eine Schaltungsanordnung zum Unterdrücken von Überschlägen zeigt.

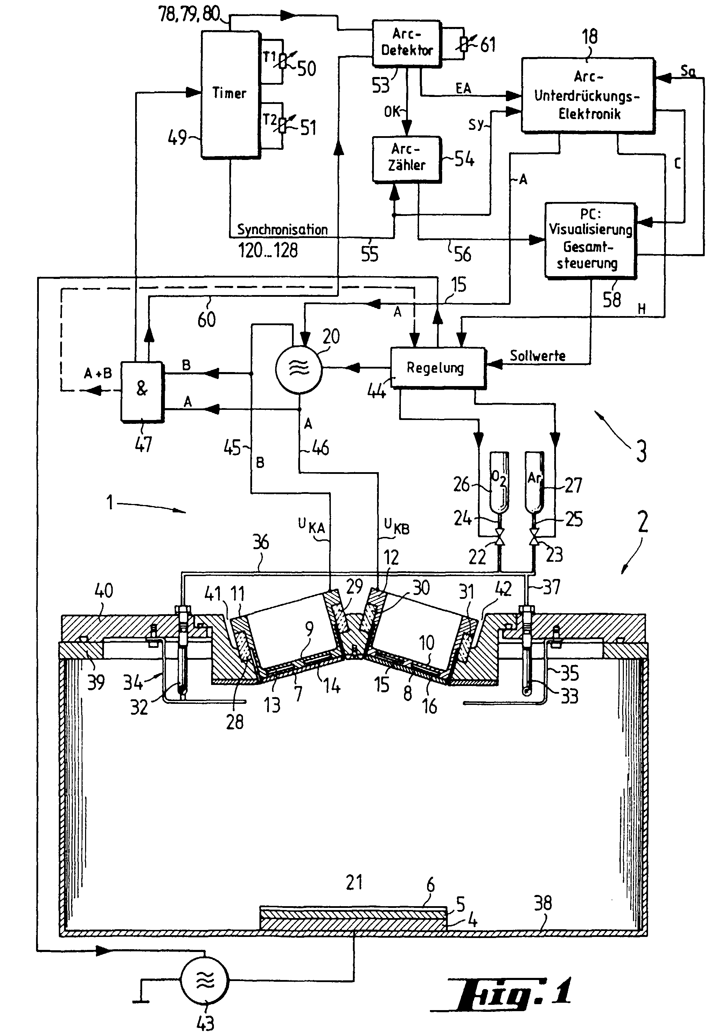

In der Fig. 1 ist eine Zerstäubungseinrichtung 1 gezeigt, mit der es möglich ist, kleine Bogenüberschläge an Kathoden zu erkennen und zu zählen sowie aufgrund der erfaßten Bogenüberschläge die Anlage gegebenenfalls abzuschalten. Das Abschalten erfolgt dabei dadurch, daß ein Mittelfrequenz-Generator 20 außer Betrieb gesetzt wird.

Die in der Fig. 1 dargestellte Anlage 1 weist im wesentlichen eine Vakuumkammer 2 und eine Beschaltungselektronik 3 auf. Am Boden der Vakuumkammer 2 ist eine Elektrode 4 vorgesehen, auf der sich ein Substrat 5 befindet, das mit einer dünnen Schicht 6 versehen werden soll. Diesem Substrat 5 liegen im oberen Bereich der Vakuumkammer 2 zwei Targets 7, 8 gegenüber, welche als langgestreckte Rechtecke ausgebildet sind und die zerstäubt werden sollen. Die Targets 7, 8 stehen jeweils über eine Targethalteplatte 9, 10 von U-förmigem Querschnitt mit einer Elektrode 11, 12 in Verbindung. Diese Elektroden 11, 12 können Teil eines Magnetrons sein, was jedoch in Fig. 1 nicht dargestellt ist. Zwischen den Targets 7, 8 und den Targethalteplatten 9, 10 sind Kühlkanäle 13 bis 16 vorgesehen.

Ähnlich einer herkömmlichen Gleichspannungs-Zerstäubungsanlage, bei der das an einer Kathode liegende negative Gleichspannungs-Potential positive Ionen direkt in Richtung auf die Targets beschleunigt, liegt bei der in der Fig. 1 gezeigten Anlage 1 eine Spannung an den Elektroden 11, 12, die von einer Mittelfrequenzquelle bzw. einem Mittelfrequenzsender 20 geliefert wird, wobei die Polarität der Spannung ständig in der Weise wechselt, daß eine der Elektroden Kathode ist, während die andere Anode ist und umgekehrt. Aufgrund dieser Mittelfrequenz-Spannung, von z. B. 40 kHz, entsteht vor den Targets 7, 8 ein Plasma, aus dem Teilchen, z. B. Argon-Ionen, auf die Targets 7, 8 zu beschleunigt werden und dort Partikel herausschlagen, die ihrerseits aufgrund ihrer kinetischen Energie in Richtung auf das Substrat 5 wandern und sich dort als Schicht 6 niederschlagen.

Für die Steuerung der dargestellten Anordnung 1 ist ein Prozeßrechner 58 vorgesehen, der Meßdaten verarbeitet und Steuerbefehle abgibt. Diesem Prozeßrechner 58, dessen Regelungsteil isoliert dargestellt und mit 44 bezeichnet ist, werden beispielsweise die Werte des in der Prozeßkammer gemessenen Partialdrucks zugeführt. Aufgrund dieser und anderer Daten kann der Prozeßrechner 58 z. B. den Gasfluß über Ventile 22, 23 regeln, die in Gaszuführungsleitungen 24, 25 liegen, die mit Gasbehältern 26, 27 in Verbindung stehen.

Die Elektroden 11, 12 sind derart auf Isolatoren 28, 29 bzw. 30, 31 gelagert, daß sich ihre ebenen Targetflächen in einer schrägen Position zur Oberfläche des Substrats 5 befinden. Diese Isolatoren 28, 29 bzw. 30, 31 haben die Gestalt von rechteckförmigen Rahmen. Eine Anlage mit zwei Elektroden, die ähnlich aufgebaut ist wie die in der Fig. 1 gezeigte Anlage, ist aus der DE-A-40 10 495 bekannt, auf die bezüglich weiterer Einzelheiten Bezug genommen wird.

Die Gaszuführungsleitungen 24, 25 führen über weitere Gasleitungen 36, 37 zu Gasduschen 32, 33, die von Abschirmungen 34, 35 umgeben sind. Das Substrat 5 ist am Boden 38 eines Kessels 39 isoliert angeordnet. Dieser Kessel 39 ist durch einen Deckel 40 abgeschlossen, der in seiner Mitte zwei Einbuchtungen 41, 42 aufweist, in denen sich die Elektroden 11, 12 befinden.

Während die beiden Elektroden 11, 12 mit dem Mittelfrequenzsender 20 verbunden sind, liegt das Substrat 5 über die Elektrode 4 an einer Spannungsquelle 43, die ihrerseits mit der Regelung 44 in Verbindung steht. Die Spannungsquelle 43 ist wegen der notwendigen elektrischen Vorspannung des Substrats 5 vorgesehen, d. h. das Substrat 5 soll auf einem definierten elektrischen Potential liegen. Als Spannungsquelle wird oft eine Hochfrequenzspannungsquelle verwendet, um die Eigenschaften der erzeugten Schichten zu verändern. Im vorliegenden Fall ist es jedoch unwesentlich, daß die Spannungsquelle eine Hochfrequenzspannungsquelle ist.

Die Regelung 44, steuert die Gasventile 22, 23 und die Hochfrequenzquellen 20 und 43. Sie wird mit dem Wert der mittleren Kathodenspannung, mit Soll-Werten aus dem Rechner 58 und mit Signalen aus einer Arc-Unterdrückungs-Elektronik 18 beaufschlagt. Die beiden Ausgänge 45, 46 des Mittelfrequenzsenders 20, der z. B. eine Wechselspannung mit einer Frequenz von 40 kHz abgibt, sind gleichspannungs-potentialfrei und symmetrisch zueinander. Sie sind außer mit den Elektroden 11, 12 auch noch mit einem Spannungs-Additions-Glied 47 verbunden, das die auf einige Volt herabtransformierte Summenspannung beider Elektroden 11, 12 an einen Zeitgeber oder Timer 49 weitergibt. Die über die Zeit gemittelte Summenspannung A + B wird der Regelung 44 zugeführt, die diese für Regelungszwecke auswertet. Der Timer 49 verwendet die Anstiegsflanken der Elektrodenspannung A + B als Kriterium, um die übrigen elektronischen Einrichtungen zu synchronisieren. Die Synchronisationsleitungen 120 . . . 128, 55 sind in der Fig. 1 zu einem Arc-Zähler 54 und zur Arc-Unterdrückungs-Elektronik 18 geführt. Am Timer 49 lassen sich verschiedene Zeiten T₁, T₂ einstellen, was durch regelbare Widerstände 50, 51 angedeutet ist. Durch die Zeiten T₁, T₂ werden die Position und die Länge eines Meßfensters eingestellt, das im Arc-Detektor 53 benutzt wird. Der Ausgang des Timers 49 ist daher über Leitungen 78, 79, 80, die hier nur als eine Leitung dargestellt sind, mit dem Eingang des Arc-Detektors 53 verbunden. Die Empfindlichkeit des Arc-Detektors ist einerseits durch das Meßfenster festgelegt. Sie kann zusätzlich durch einen Spannungstrigger eingestellt werden, was durch einen regelbaren Widerstand 61 angedeutet ist.

In dem Addierer 47 werden die beiden auf den Leitungen 45, 46 anliegenden Spannungen dynamisch addiert und gleichzeitig auf einen Pegel von einigen Volt herabtransformiert. Dynamisch addieren bedeutet hierbei, daß (A + B) (t) = A (t) + B (t) bestimmt wird, d. h. daß keine Mittelwerte gebildet werden, wie es für die Regelung 44 der Fall ist. Das Signal (A + B) (t) wird zur Feststellung der Mikroüberschläge durch den Arc-Detektor 53 verwendet, wozu vom Addierer 47 die Leitung 60 zum Arc-Detektor 53 führt.

Der Arc-Detektor steht seinerseits mit einem Arc-Zähler 54 in Verbindung. Der Arc-Zähler 54 kann durch einen Mikroprozessor realisiert sein, der durch ein spezielles Programm gesteuert wird. Vom Arc-Zähler 54 führt eine Leitung 56 zum Rechner 58, wobei sich auf dieser Leitung 56 das Analogsignal U = 2 log (N + 1) befindet. N ist dabei die Anzahl von Mikro-Arcs pro Sekunde.

Für die vorliegende Erfindung ist die Arc-Unterdrückungs-Elektronik 18 von besonderer Bedeutung. Sie wird mit einem Synchronisationssignal Sy aus dem Timer 49, mit einem Signal EA aus dem Arc-Detektor 53 und mit einem Signal Sa aus dem Rechner 58 beaufschlagt.

Die Arc-Unterdrückungs-Elektronik gibt ihrerseits ein Signal H an die Regelung 44, ein Signal C an den Rechner 58 und ein Signal A an den Mittelfrequenzsender 20 ab. Bei diesem Sender 20 muß es sich um einen schnell abschaltbaren Sender handeln, wie er beispielsweise von der Fa. Advanced Energy Industries, Inc., Fort Collins, Colorado 80525 unter der Bezeichnung PE 5000 vertrieben wird.

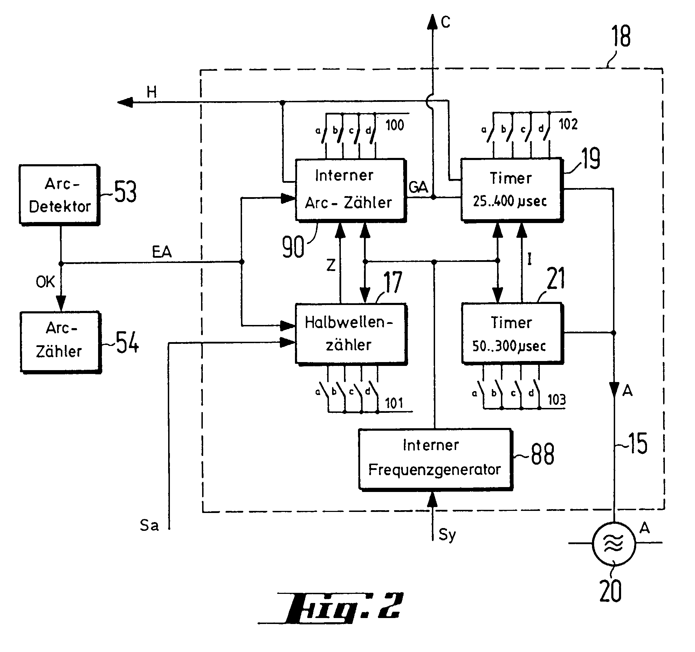

Mit Hilfe der Arc-Unterdrückungs-Elektronik 18 wird bei Auftreten einer unzulässig großen Zahl von Mikro-Arcs der Mittelfrequenzsender 20 abgeschaltet. Dabei wird die Dauer der Senderschaltung durch besondere Maßnahmen festgelegt, wie im Zusammenhang mit Fig. 2 noch näher erläutert wird.

In der Fig. 2 ist die Arc-Unterdrückungselektronik 18 näher dargestellt. Man erkennt hierbei, daß sie im wesentlichen aus einem "internen Arc-Zähler" 90, einem Halbwellenzähler 17, einem ersten Timer 19, einem zweiten Timer 21 sowie einem internen Frequenzgenerator 88 besteht.

Der Arc-Detektor 53 ist in der Lage, einzelne Mikro-Arcs zu detektieren. Hierzu wird im Fall eines 40 kHz-Senders 20 in einem Zeitraster von 12,5 µs in einem Meßfenster der Spannungsverlauf abwechselnd an den beiden Elektroden 11, 12 der Doppelkathodenanordnung gemessen. Der Spannungsverlauf wird dem Arc-Detektor 53 vom Addierer 47 über die Leitung 60 zugeführt. Bricht die Spannung innerhalb des Meßfensters zusammen, d. h. wird ein Triggerwert unterschritten, wird dieses Ereignis als Mikro-Arc definiert. Ein großer Arc kündigt sich dadurch an, daß Spannungsunterschreitungen z. B. an einer Kathode in Form einer Serie von Mikro-Arcs detektiert werden. Im Gegensatz zu einem einzelnen Mikro-Arc, der nach Ablauf von 12,5 µs wieder automatisch erlischt, bedeutet ein großer Arc, daß ein Kurzschluß bestehen bleibt und hierdurch an der betreffenden Kathode keine Spannung mehr auftritt. Einzelheiten hierzu sind in der Patentanmeldung DE-A-44 20 951.7 ausgeführt.

Wurde ein einzelner Mikro-Arc vom Arc-Detektor 53 erkannt, so schickt er in diesem Fall ein Signal EA sowohl an den Halbwellenzähler 17 als auch an den internen Arc-Zähler 90, die dadurch initialisiert werden. Der Halbwellenzähler 17 zählt daraufhin h einzelne Halbwellen ab, womit eine Zeit ΔT in Einheiten von 12,5 µs festgelegt ist. Während dieser Zeit steht das Signal Z an der Leitung 61 an, die zu dem internen Arc-Zähler 90 führt. Der interne Arc-Zähler 90 wird durch das Signal Z in einen aktiven Zustand geschaltet. Wenn im Zeitintervall ΔT eine Anzahl von n Mikro-Arcs auftritt, stellt dies den Beginn eines großen Arcs dar. Welche Werte für ΔT und n einzustellen sind, ergibt sich aus der Erfahrung.

Der Zusammenhang zwischen der Zahl h der Halbwellen und der Zahl n der Mikro-Arcs kann z. B. durch folgende Tabelle hergestellt werden.

| | | | | |
|---|---|---|---|---|
| i = Hochzahl oder Potenz | 1 | 2 | 3 | 4 |
| h = Zahl 101 der Halbwellen gleich 2⁽ⁱ⁾ - 1 | 1 | 3 | 7 | 15 |
| n = Zahl 100 der Micro-Arcs gleich 2^{(i - 1)} | 1 | 2 | 4 | 8 |

Hierbei weisen die Bezugszahlen 101, 100 in der Tabelle auf Kaskaden hin, mit deren Hilfe sich die verschiedenen Halbwellenzahlen und Mikro-Arc-Zahlen einstellen lassen. Es können auch andere Kombinationen von h und n, n ≤ h, an den Schalter-Kaskaden 100, 101 eingestellt werden. Nachfolgend wird jedoch der Einfachheit halber auf die vorstehende Tabelle Bezug genommen.

Die in der Tabelle eingetragenen Kombinationen von n und h sind wie nachfolgend zu interpretieren:
- i = 1: Das ist der einfachste Fall, in dem jeder Arc gleichzeitig auch als großer Arc (GA) angesehen wird
- i = 2: wenn in drei aufeinanderfolgenden Halbwellen zwei Mikro-Arcs auftreten, wird das als ein GA angesehen, und zwar auch dann, wenn diese zwei Arcs nur an einer Kathode festgestellt werden
- i = 3: in sieben aufeinanderfolgenden Halbwellen müssen mindestens vier Einzelereignisse durch den Arc-Detektor 53 registriert werden. Diese Einzelereignisse können alle auf einer einzelnen Elektrode 11 oder 12 auftreten
- i = 4: in fünfzehn aufeinanderfolgenden Halbwellen müssen mindestens acht Einzelereignisse durch den Arc-Detektor 53 registriert werden, damit das Signal GA ausgelöst wird. Diese Einzelereignisse können alle auf einer einzigen Kathode auftreten.

Grundsätzlich ist es also auch möglich, festzustellen, ob Mikro-Arcs oder große Arcs nur an einer der Kathoden auftreten.

Die beiden Zähler 17, 90 werden mit dem gleichen Synchronisier-Signal Sy beaufschlagt, um ein korrektes Abzählen der Mikro-Arcs und der einzelnen Zeiten ΔT, tₐ, tᵢ sicherzustellen.

Treten also in der vorgegebenen Zeit ΔT mindestens n ≤ h Mikro-Arcs auf, wird das Signal GA vom Arc-Zähler 90 aktiviert, das für einen "großen Arc" steht, und auf den Timer 19 gegeben. Der Timer 19 gibt hierauf für eine vorgebbare Zeit ein Ausschaltsignal A auf die Leitung 15, welches den Sender 20 abschaltet. Die Abschaltzeit tₐ liegt dabei zwischen 25 und 400 µs.

Da nach Abschalten des Senders 20 beim anschließenden Hochfahren der Leistung der Prozeß eine bestimmte Zeit, die erfahrungsgemäß bei ca. 150 µs liegt, benötigt, um wieder seinen Normalzustand zu erreichen, müssen die in dieser Zeit notwendigerweise wom Arc-Detektor 53 registrierten Spannungsunterschreitungen im Arc-Detektor 53 ignoriert werden. Dieser "Ignore"-Zustand wird dem Timer 19 mit Hilfe des Signals I über die Leitung 62 mitgeteilt. Die Dauer tᵢ für den "Ignore"-Zustand wird durch den Timer 21 festgelegt. Zu diesem Zweck wird zum Zeitpunkt des Wiedereinschaltens des Senders 20, also nach Abaluf von tₐ der zweite Timer 21 für die Zeit tᵢ aktiviert, die bei einer Senderfrequenz von 40 kHz zwischen 50 und 300 µs liegen kann. Gleichzeitig wird auf die Leitung 62 das Signal I gesetzt, das für "ignorieren" steht. Während dieser Zeit tᵢ ignoriert der Timer 19 die eventuell ankommenden Signale GA, so daß diese Signale nicht zu einer erneuten Senderabschaltung führen.

Das Zusammenspiel der beiden Timer 19, 21 und ihre Reaktion auf das Signal GA sind somit für die Abschaltvorgänge und für das Wiederanschalten des Mittelfrequenz-Senders 20 von großer Bedeutung.

Die Timer 19, 21 sind im beschriebenen Ausführungsbeispiel in Form von digitalen Zählern aufgebaut, so daß sich die Zeiten tₐ und tᵢ als ganzzahlige Vielfache einer halben oder ganzen Grundperiode ergeben. Die Timer 19, 21 sind daher ebenfalls mit Schalter-Kaskaden 102, 103 versehen, mit deren Hilfe die Zeiten tₐ, tᵢ geeignet eingestellt werden können. Die einzelnen Schalter der Kaskaden sind bei allen Kaskaden mit a, b, c, d bezeichnet. Sind die Timer 19, 21 digitale Zähler, so ist das Synchronisationssignal Sy auch an die beiden Timer 19, 21 zu führen.

Die Timer 19, 21 können auch als Analogbausteine aufgebaut sein. In diesem Fall ist eine Synchronisation von 19, 21 nicht erforderlich.

Das Signal GA kann auch gleichzeitig als Zählsignal C verwendet werden, um z. B. die Gesamtzahl der auftretenden großen Arcs in einer bestimmten Zeiteinheit zu zählen.

Das Signal OK in Fig. 1 und Fig. 2 ist mit dem Signal EA in Fig. 2 identisch. Die unterschiedliche Bezeichnung soll lediglich darauf hinweisen, daß es sich immer um Signale handelt, die auf Einzel-Arcs hinweisen, d. h. auf Mikro-Arcs, um eine Unterscheidung zu den großen Arcs (GA) zu treffen, die in der Praxis als eine Sequenz von Mikro-Arcs zu beobachten sind, wie bereits oben näher erläutert wurde.

Das Signal H, das zur Regelung 44 geleitet wird, ist dann aktiviert, wenn einzelne Arcs auftreten oder wenn bei und nach der Senderabschaltung die Zeiten tₐ und tᵢ andauern. Solange H aktiv ist, werden alle Regelkreise in der Regelung 44 deaktiviert, so daß nach dem Wiederanfahren des Senders 20 der Ausgangszustand des Prozesses vor der Abschaltung schnell wieder erreicht werden kann.

## Patentansprüche

1. Einrichtung für die Unterdrückung von Überschlägen in Kathoden-Zerstäubungseinrichtungen, bei denen an wenigstens einer Elektrode eine Wechsel-Spannungsquelle anliegt, **dadurch gekennzeichnet**, daß
a) die Wechsel-Spannungsquelle (20) eine Mittelfrequenz-Spannungsquelle ist,
b) eine Einrichtung (53) zum Erkennen von Mikroüberschlägen vorgesehen ist,
c) eine Einrichtung (90) zum Zählen der Anzahl der auftretenden Mikroüberschläge vorgesehen ist,
d) eine Einrichtung (19, 21) vorgesehen ist, die bei Vorliegen einer bestimmten Zahl von Mikroüberschlägen oder bei Vorliegen einer bestimmten Häufigkeit von Mikro-überschlägen Maßnahmen zum Verhindern von großen Überschlägen trifft.

2. Einrichtung für die Unterdrückung von Überschlägen in Kathoden-Zerstäubungseinrichtungen, bei denen an wenigstens einer Elektrode eine Wechsel-Spannungsquelle anliegt, **gekennzeichnet durch**
a) eine Einrichtung (53) zum Erkennen von Mikro-Überschlägen
b) eine Einrichtung (90) zum Zählen der Anzahl von aufgetretenen Mikro-überschlägen
c) eine Einrichtung (17) zum Zählen der Halbwellen der Wechselspannungsquelle (20)
d) eine Einrichtung (19) zum Abschalten der Wechselspannungsquelle (20) bei Vorliegen eines bestimmten Verhältnisses zwischen den gezählten Halbwellen und den gezählten Mikro-Überschlägen
e) eine Einrichtung (21) zum Deaktivieren der Abschaltung durch die Einrichtung (19) zum direkten zeitlichen Anschluß an die Wiedereinschaltung der Wechselspannungsquelle (20).

3. Einrichtung nach Anspruch 2, **dadurch gekennzeichnet**, daß die Einrichtung (90) zum Zählen der Mikro-Überschläge und die Einrichtung (17) zum Zählen der Halbwellen mit der Frequenz der Wechselspannungsquelle (20) synchronisiert sind.

4. Einrichtung nach Anspruch 2, **dadurch gekennzeichnet**, daß die Wechselspannungsquelle (20) ein schnell abschaltbarer Mittelfrequenzsender ist.

5. Einrichtung nach Anspruch 2, **dadurch gekennzeichnet**, daß das Abschalten der Wechselspannungsquelle (20) für eine vorgebbare Zeit erfolgt.

6. Einrichtung nach Anspruch 2, **dadurch gekennzeichnet**, daß die Dauer der Senderabschaltung durch einen Zeitgeber (19) festgelegt ist.

7. Einrichtung nach Anspruch 2, **dadurch gekennzeichnet**, daß nach dem Wiedereinschalten der Wechselspannungsquelle (20) nach der durch den Zeitgeber (19) festgelegten Zeit die im Anschluß hieran auftretenden Mikro-Überschläge für eine durch einen weiteren Zeitgeber (21) festgelegte Zeit ignoriert werden.

8. Einrichtung nach Anspruch 6 oder Anspruch 7, **dadurch gekennzeichnet**, daß die Zeitgeber (19, 21) als digitale Zähler aufgebaut sind, welche die Zeiten als ganzzahlige Vielfache einer halben oder ganzen Grundperiode der Frequenz der Wechselspannungsquelle (20) ermitteln.

9. Einrichtung nach Anspruch 6 oder Anspruch 7, **dadurch gekennzeichnet**, daß die Zeitgeber (19, 21) als analoge Bauelemente aufgebaut sind.

10. Einrichtung nach Anspruch 2, **dadurch gekennzeichnet**, daß die Einrichtungen (90, 17, 19, 21) für die Dauer der Senderabschaltung durch einen internen Frequenzgenerator (88) synchronisiert werden, dessen Eigenfrequenz vorzugsweise das Doppelte der Frequenz der Wechselspannungsquelle (20) beträgt.

11. Einrichtung nach Anspruch 2, **dadurch gekennzeichnet**, daß das Abschalten der Wechselspannungsquelle (20) über eine Lichtfaserleitung erfolgt.

12. Einrichtung nach Anspruch 2, **dadurch gekennzeichnet**, daß für die Aktivierung der Einrichtung (18) ein Rechner vorgesehen ist, der mit dieser Einrichtung (18) über eine Lichtleitfaserleitung verbunden ist.

13. Einrichtung nach Anspruch 2, **dadurch gekennzeichnet,** daß es sich bei der Kathoden-Zerstäubungseinrichtung um eine Doppelkathodenanordnung (9, 10) handelt.

14. Einrichtung nach Anspruch 6 und Anspruch 7, **dadurch gekennzeichnet**, daß die beiden Zähler (17, 90) so eingestellt sind, daß sie zwischen kleinen und großen Mikro-Überschlägen unterscheiden können.

15. Einrichtung nach Anspruch 6 und Anspruch 13, **dadurch gekennzeichnet**, daß die beiden Zähler (17, 90) so eingestellt sind, daß sie feststellen, ob ein Mikro-Überschlag über mehrere Perioden der Wechselspannung an einer der beiden Kathoden (9, 10) ansteht.

## Claims

1. Device for suppressing flashovers in cathode sputtering installations in which at least one electrode is connected to an AC voltage source, **characterized in that**
a) the AC voltage source (20) is a medium-frequency voltage source,
b) a device (53) for recognizing micro-flashovers is provided,
c) a device (90) for counting the number of micro-flashovers is provided,
d) a device (19, 21) is provided which, after the occurrence of a given number of micro-flashovers or in the presence of a given frequency of micro-flashovers, takes measures to prevent large flashovers.

2. Device for suppressing flashovers in cathode sputtering installations in which at least one electrode is connected to an AC voltage source, **characterized by**
a) a device (53) for recognizing micro-flashovers,
b) a device (90) for counting the number of micro-flashovers occurring,
c) a device (17) for counting the halfwaves of the AC voltage source (20),
d) a device (19) for switching off the AC voltage source (20) in the presence of a given ratio of counted half waves to counted micro-flashovers,
e) a device (21) for deactivating the switch-off by device (19) for the direct time connection to the switch-on of the AC voltage source (20).

3. Device as stated in claim 2, **characterized in that** the device (90) for counting the micro-flashovers and the device (17) for counting the halfwaves are synchronized with the frequency of the AC voltage source (20).

4. Device as stated in claim 2, **characterized in that** the AC voltage source (20) is a fast-switched medium-frequency transmitter.

5. Device as stated in claim 2, **characterized in that** the switching off of the AC voltage source (20) takes place for a given length of time.

6. Device as stated in claim 2, **characterized in that** the length of time during which the transmitter is switched off is determined by a timer (19).

7. Device as stated in claim 2, **characterized in that** after the AC voltage source (20) is again switched on after the time determined by the timer (19), the micro-flashovers occurring subsequently are ignored for a length of time determined by a further timer (21).

8. Device as stated in claim 6 or claim 7, **characterized in that** the timers (19, 21) are built as digital counters which determine the times as integer multiples of one half or one whole fundamental period of the frequency of the AC voltage source (20).

9. Device as stated in claim 6 or claim 7, **characterized in that** the timers (19, 21) are built as analog elements.

10. Device as stated in claim 2, **characterized in that** the devices (90, 17, 19, 21) for the length of time during which the transmitter is switched off are synchronized by an internal frequency generator (88) whose intrinsic frequency is perferably the twofold of the frequency of the AC voltage source (20).

11. Device as stated in claim 2, **characterized in that** the switching off of the AC voltage source (20) takes place via a fiberoptic line.

12. Device as stated in claim 2, **characterized in that** for the activation of the device (18) a computer is provided which is connected with this device (18) via a fiberoptic line.

13. Device as stated in claim 2, **characterized in that** the cathode sputtering installation is a double cathode arrangement (9, 10).

14. Device as stated in claim 6 and claim 7, **characterized in that** the two counters (17, 90) are set so that they can differentiate between small and large micro-flashovers.

15. Device as stated in claim 6 and claim 13, **characterized in that** the two counters (17, 90) are set so that they can determine whether or not a micro-flashover is present over several periods of the AC voltage at one of the two cathodes (9, 10).

## Revendications

1. Dispositif pour la suppression des amorçages dans des dispositifs de pulvérisation cathodique dans lesquels une source de tension alternative est appliquée à au moins une électrode, caractérisé en ce que
a) la source de tension alternative (20) est une source de moyenne tension,
b) il est prévu un dispositif (53) destiné à détecter des micro-amorçages
c) il est prévu un dispositif (90) pour compter le nombre des micro-amorçages qui se produisent
d) il est prévu un dispositif (19, 21) qui, en présence d'un nombre déterminé de micro-amorçages, ou en présence d'une fréquence donnée de micro-amorçages, prend des dispositions pour éviter de gros amorçages.

2. Dispositif pour la suppression des amorçages dans des dispositifs de pulvérisation cathodique dans lesquels une source de tension alternative est appliquée à au moins une électrode, caractérisé par
a) un dispositif (53) destiné à détecter des micro-amorçages
b) un dispositif (90) pour compter le nombre des micro-amorçages qui se sont produits
c) un dispositif (17) pour compter les demi-ondes de la source de tension alternative (20)
d) un dispositif (19) pour mettre la source de tension alternative (20) hors circuit en présence d'un certain rapport entre les demi-ondes comptées et les micro-amorçages comptés
e) un dispositif (21) pour désactiver la mise hors circuit exécutée par le dispositif (19) directement à la suite dans le temps de la remise en circuit de la source de tension alternative (20).

3. Dispositif selon la revendication 2, caractérisé en ce que le dispositif (90) pour compter des micro-amorçages et le dispositif (17) pour compter des demi-ondes sont synchronisés avec la fréquence de la source de tension alternative (20) .

4. Dispositif selon la revendication 2, caractérisé en ce que la source de tension alternative est un émetteur de moyenne fréquence pouvant être mis rapidement hors circuit.

5. Dispositif selon la revendication 2, caractérisé en ce que la mise hors circuit de la source de tension alternative (20) s'effectue pour un temps pouvant être prédéterminé.

6. Dispositif selon la revendication 2, caractérisé en ce que la durée de la mise hors circuit de l'émetteur est fixée par une horloge (19).

7. Dispositif selon la revendication 2 caractérisé en ce qu'après la remise en circuit de la source de tension alternative (20) après le temps fixé par l'horloge (19), les micro-amorçages qui se produisent à la suite de cette opération sont ignorés pendant un temps fixé par une autre horloge (21).

8. Dispositif selon la revendication 6 ou la revendication 7, caractérisé en ce que les horloges (19, 21) sont constituées par des compteurs numériques qui déterminent les temps sous la forme de multiples entiers d'une demi-période de base ou d'une période de base complète de la fréquence de la source de tension alternative (20).

9. Dispositif selon la revendication 6 ou la revendication 7, caractérisé en ce que les horloges (19, 21) sont constituées par des composants analogiques.

10. Dispositif selon la revendication 2, caractérisé en ce que les dispositifs (90, 17, 19, 21) sont synchronisés pendant la durée de la mise hors circuit de l'émetteur par un générateur de fréquence interne (88) dont la fréquence propre est de préférence le double de la fréquence de la source de tension alternative (20).

11. Dispositif selon la revendication 2, caractérisé en ce que la mise hors circuit de la source de tension alternative (20) s'effectue par l'intermédiaire d'un conducteur de lumière à fibre.

12. Dispositif selon la revendication 2, caractérisé en ce qu'il est prévu pour l'activation du dispositif (18) un calculateur qui est relié à ce dispositif (18) par un conducteur de lumière à fibre.

13. Dispositif selon la revendication 2, caractérisé en ce que le dispositif de pulvérisation cathodique est constitué par un dispositif à double cathode (9, 10).

14. Dispositif selon la revendication 6 ou la revendication 7, caractérisé en ce que les deux compteurs (17, 90) sont réglés de manière à pouvoir distinguer entre les petits et les grands micro-amorçages.

15. Dispositif selon la revendication 6 et la revendication 13 caractérisé en ce que les deux compteurs (17, 90) sont réglés de manière à vérifier s'il se manifeste une micro-amorçage à l'une des deux cathodes (9, 10) sur plusieurs périodes de la tension alternative.
